# EUROPÄISCHE PATENTSCHRIFT

(11) **EP 1 999 757 B1**
(45) Veröffentlichungstag und Bekanntmachung des Hinweises auf die Patenterteilung: **08.09.2010**
(21) Anmeldenummer: 07723469.8
(22) Anmeldetag: 21.03.2007
(51) Int. Cl.: G11C 17/00, G06K 19/07

(54) **VERFAHREN ZUM PROGRAMMIEREN EINER ELEKTRONISCHEN SCHALTUNG SOWIE ELEKTRONISCHE SCHALTUNG**
METHOD FOR PROGRAMMING AN ELECTRONIC CIRCUIT AND ELECTRONIC CIRCUIT
PROCÉDÉ DE PROGRAMMATION D'UN CIRCUIT ÉLECTRONIQUE ET CIRCUIT ÉLECTRONIQUE

(30) Priorität: 22.03.2006 DE 102006013605
(43) Veröffentlichungstag der Anmeldung: 10.12.2008
(73) Patentinhaber: PolyIC GmbH & Co. KG, 90763 Fürth (DE)
(72) Erfinder: ULLMANN, Andreas, 90513 Zirndorf (DE); FIX, Walter, 90427 Nürnberg (DE)
(74) Vertreter: Zinsinger, Norbert
(86) Internationale Anmeldenummer: PCT/EP2007/002512
(87) Internationale Veröffentlichungsnummer: WO 2007/107357

(56) Entgegenhaltungen:
- EP-A- 1 296 280
- WO-A-02/23553

## Beschreibung

Die Erfindung betrifft ein Verfahren zum Programmieren einer elektronischen Schaltung sowie eine elektronische Schaltung, welche mindestens eine organische elektrische Funktionsschicht und mindestens eine Datenspeicher-Einheit aufweist, wobei die Datenspeicher-Einheit mit zwei elektrisch leitenden Schichtkontakten ausgebildet ist.

Aus DE 100 45 192 A1 sind Verfahren zur Herstellung elektronischer Schaltungen enthaltend Datenspeicher, die auf organischem Material basieren, bekannt. Die Datenspeicher werden in Kombination mit einer organischen integrierten Schaltung (integrated plastic circuit) eingesetzt, insbesondere für einen RFID-Tag (RFID-tags: radio frequency identification-tags). Die Programmierung der elektronischen Schaltung beziehungsweise das Beschreiben des Datenspeichers erfolgt hier entweder durch gezieltes Weglassen von Leiterbahnen oder Bauelementen der elektronischen Schaltung bereits bei deren Herstellung oder durch Manipulation von Leiterbahnen derart, dass diese nachträglich leitend oder nicht-leitend gemacht werden. Dabei werden Leiterbahnen durch Lasereinstrahlung oder gezielt eingebrachte Hitze nicht-leitend gemacht, durch chemische Behandlung wie z.B. Base/Säurestempel leitfähige Bereiche nicht-leitend gemacht oder umgekehrt, durch mechanische Behandlung Leiterbahnen durchtrennt, durch elektrische Spannung ein Kurzschluss und damit durch lokale Überhitzung eine Zerstörung einer Leiterbahn bewirkt, Leiterbahnen werden als "fusable links" ausgebildet, welche durch Strom unterbrochen werden oder es wird durch Lasereinstrahlung die Elektrizitäts-Konstante eines Materials geändert.

Elektronische Schaltungen, insbesondere organische integrierte Schaltkreise auf der Basis von organischen Feld-Effekt-Transistoren (OFETs) werden für mikroelektronische Massenanwendungen und Wegwerf-Produkte wie kontaktlos auslesbare Identifikations- und Produkt- "tags" benötigt. Dabei kann auf das exzellente Betriebsverhalten der Silizium-Technologie verzichtet werden, aber dafür sollen sehr niedrige Herstellungskosten und hohe mechanische Flexibilität gewährleistet sein. Die Bauteile sind typischerweise Einwegprodukte.

Die EP 1296 280 offenbart ein Verfahren und eine elektronische schaltung gemäß dem Oberbegriff der Ansprüche 1 und 5.

Aufgabe der Erfindung ist es, ein weiteres Verfahren zur Programmierung einer elektronischen Schaltung mit einem Datenspeicher sowie eine weitere elektronische Schaltung mit einem Datenspeicher zu schaffen.

Die Aufgabe wird für das Verfahren gemäß den Merkmalen des Anspruchs 1 gelöst.

Die Speicherung eines Datenbits in einer elektronischen Schaltung ist durch ein derartiges Verfahren in besonders einfacher und kostengünstiger Weise durchführbar. Insbesondere ist das erfindungsgemäße Verfahren zur Programmierung integrierter Schaltungen, wie zum Beispiel von Transponder-Schaltungen, geeignet und ermöglicht eine individuelle Programmierung der Datenspeicher-Einheit und damit der elektronischen Schaltung sowohl während der Herstellung der elektronischen Schaltung wie auch beim Endabnehmer der elektronischen Schaltung. Die Programmierung erfolgt dabei irreversibel.

Besonders geeignet ist das erfindungsgemäße Verfahren zur Herstellung gedruckter Schaltungen, insbesondere gedruckter organischer Schaltungen, die mindestens eine gedruckte organische Funktionsschicht enthalten und auf einem flexiblen Substrat erzeugt werden. Ein Datenspeicher-Element wird dabei beispielsweise gleichzeitig und vorzugsweise in einer Ebene mit einer Elektrodenschicht, beispielsweise eines organischen Logikelements, gebildet. Daraufhin kann die gewünschte Programmierung erfolgen und schließlich weitere Schichten der elektronischen Schaltung oder eine Verkapselungsschicht aufgebracht werden. Das erfindungsgemäße Verfahren ist in ein Rolle-zu-Rolle-Verfahren, bei welchem ein flexibles Substrat zur Aufnahme der elektronischen Schaltung von einer Rolle abgespult und nach Aufbringen von elektrischen Funktionsschichten auf eine zweite Rolle aufgewickelt wird, optimal integrierbar.

Die Aufgabe wird für die elektronische Schaltung gemäß den Merkmalen des Anspruchs 5 gelöst.

Eine solche elektronische Schaltung, die insbesondere durch das erfindungsgemäße Verfahren gebildet werden kann, ist besonders kostengünstig. Die Datenspeicher-Einheit ist nicht noch einmal oder anderweitig beschreibbar. Weiterhin ist die Datenspeicher-Einheit Schichtabfolgen-kompatibel in die, insbesondere zumindest teilweise durch ein Druckverfahren ausgebildete, elektronische Schaltung integrierbar. Die elektronische Schaltung ist vorzugsweise eine integrierte Schaltung, insbesondere eine organische integrierte Schaltung, die zumindest eine organische elektrische Funktionsschicht umfasst, die durch Drucken gebildet ist.

Der Begriff "organisches Material" umfasst hier alle Arten von organischen, metallorganischen und/oder anorganischen Kunststoffen, die im Englischen z. B. mit "plastics" bezeichnet werden. Es handelt sich um alle Arten von Stoffen mit Ausnahme der Halbleiter, die die klassischen Dioden bilden (Germanium, Silizium) und der typischen metallischen Leiter. Eine Beschränkung im dogmatischen Sinn auf organisches Material als Kohlenstoff-enthaltendes Material ist demnach nicht vorgesehen, vielmehr ist auch an den breiten Einsatz von z. B. Silikonen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich.

Als Träger für die elektronische Schaltung können sowohl starre als auch flexible Substrate verwendet werden. Bevorzugt sind hier flexible Substrate in Form von Folien oder Folienbahnen, welche kontinuierlich im Rolle-zu-Rolle-Verfahren verarbeitet und bedruckt werden können. Als Substrat-Materialien kommen beispielsweise Papier, PET, Polyester, PEN oder Polyamide in Frage, welche vorzugsweise eine Dicke im Bereich von 12 bis 100µm aufweisen.

Für das Verfahren hat es sich besonders bewährt, wenn die flüssige Substanz aufgetropft oder aufgetupft wird. Die Schichtkontakte und die Bereiche zwischen den zwei Schichtkontakten kommen dabei im Idealfall nur mit der flüssigen Substanz in Berührung, so dass die Gefahr einer Verunreinigung, insbesondere organischer Materialien, oder einer Beschädigung angrenzender Schichten der elektronischen Schaltung minimiert wird.

Durch die oben genannten Prozeß-Schritte lässt sich der Speicher nur ein einziges Mal beschreiben. Die Programmierung kann bei der Herstellung des Tags oder des Produktes erfolgen oder beim Montieren der Elektronik (z. B. Kofferanhänger, elektronische Briefmarke, Ticket, wobei jedes Ticket einen eigenen Speicherinhalt hat). Gleichzeitig kann diese Technik auch dafür benutzt werden, eine Elektronik, wie z. B. einen elektronischen Barcode oder ein elektronisches Ticket nach Gebrauch gezielt unbrauchbar zu machen, indem eine bestimmte Bitanordnung nach Gebrauch (beim Entwerten des Tickets, beim Bezahlen an der Kasse) gezielt einprogrammiert wird oder der Speicher unleserlich gemacht wird.

Dabei hat es sich als vorteilhaft erwiesen, wenn lediglich ein einzelner Tropfen der flüssigen Substanz aufgebracht wird. Ein einzelner Tropfen kann exakt dosiert und plaziert werden, wobei über die Dosiermenge an flüssiger Substanz der geeignete Tropfen-Durchmesser ausgebildet wird.

Vorzugsweise erfolgt eine Trocknung der flüssigen Substanz, so dass eine elektrisch leitende Trockensubstanz umfassend den elektrisch leitenden Stoff gebildet wird, welche die beiden elektrisch leitenden Schichtkontakte elektrisch leitend miteinander verbindet. Wird die flüssige Substanz nicht sofort getrocknet oder zum erstarren gebracht, ist darauf zu achten, dass ein Auftrag weiterer Schichten nicht zu einem Verwischen der flüssigen Substanz führt. Dies kann durch die Einstellung geeigneter Viskositäten für die flüssige Substanz und der darüber zu druckenden oder anderweitig aufzubringenden Schichtmaterialien sichergestellt werden.

Die flüssige Substanz kann dabei in Form einer Lösung, einer Suspension, einer Tinte oder einer Paste aufgebracht werden. Je dünnflüssiger die flüssige Substanz verwendet wird, desto einfacher gestaltet sich deren Dosierung und Plazierung.

Besonders bevorzugt ist es, wenn die flüssige Substanz mittels eines Tintenstrahldruckers aufgebracht wird.

Weiterhin hat es sich bewährt, wenn die flüssige Substanz in Form einer Schmelze aufgebracht wird, dass eine Abkühlung der flüssigen Substanz erfolgt und dass eine elektrisch leitende erstarrte Substanz umfassend den elektrisch leitenden Stoff gebildet wird, welche die beiden elektrisch leitenden Schichtkontakte elektrisch leitend miteinander verbindet.

Vorteilhaft ist hierbei, wenn die Schmelze aufgetropft oder mittels eines Tintenstrahldruckers oder mittels eines Thermotransferverfahrens aufgebracht wird.

Die flüssige Substanz weist vorzugsweise einen Gehalt an elektrisch leitendem Stoff im Bereich von 10 bis 90, bevorzugt von 60 bis 80 Gew.-% auf. Je nachdem, ob eine Lösung, Suspension, Tinte, Paste oder Schmelze als flüssige Substanz dient, sind unterschiedliche minimale Gehalte an elektrisch leitendem Stoff erforderlich, um eine elektrisch leitende Verbindung zwischen den zwei Schichtkontakten eines Datenspeicher-Elements auszubilden.

Der elektrisch leitende Stoff wird aus der Gruppe der metallischen und/oder organischen leitenden Materialien ausgewählt, wobei bevorzugt Edelmetalle wie Gold oder Silber und als leitende organische Materialien vorzugsweise Pani, Pedot oder Polypyrrol sowie Kohlenstoff eingesetzt werden. So kann als flüssige Substanz eine Leitsilber-Paste oder Druckfarbe mit hohem Kohlenstoff-Anteil, wie beispielsweise Druckerschwärze, dienen.

Im Fall der elektronischen Schaltung weist in Fall a) die elektrisch leitende Trockensubstanz oder in Fall b) die elektrisch leitende erstarrte Substanz den elektrisch leitenden Stoff aus der Gruppe der metallischen und/oder organischen leitenden Materialien auf. Von der Trockensubstanz oder der erstarrten Substanz können weitere Materialien, wie Bindemittel, Klebstoffe, Reste von chemischen Additiven wie Verflüssigern oder Stabilisatoren, Farbstoffe oder ähnliches umfasst sein.

Es hat sich bewährt, wenn die mindestens eine organische elektrische Funktionsschicht gedruckt wird. Elektrodenschichten können aber beispielweise auch photolithographisch, durch Kathodenzerstäubung oder Aufdampfen gebildet werden.

Weiterhin hat es sich bewährt, wenn die zwei elektrisch leitenden Schichtkontakte einer Datenspeicher-Einheit in einer Ebene mit einer elektrisch leitenden Funktionsschicht, insbesondere im gleichen Arbeitsgang wie die elektrisch leitende Funktionsschicht, gebildet werden.

Weiterhin ist es vorteilhaft, auf die elektrisch leitende Trockensubstanz oder auf die elektrisch leitende erstarrte Substanz mindestens eine elektrische Funktionsschicht der elektronischen Schaltung aufzubringen. Besonders bevorzugt ist es, stromführende Elektrodenschichten oder Leiterbahnen darüber zu führen, um einen Zugang zur Datenspeicher-Einheit zu behindern und somit Versuche, eine Veränderung der Programmierung vorzunehmen, zu unterbinden. Alternativ kann die elektrisch leitende Trockensubstanz oder die elektrisch leitende erstarrte Substanz mit einer Versiegelungsschicht bedeckt werden.

Die elektrisch leitende Trockensubstanz oder die elektrisch leitende erstarrte Substanz wird durch ein solches Vorgehen in den Aufbau der elektronischen Schaltung integriert und optimal vor einer späteren unerwünschten Umprogrammierung geschützt.

Im Hinblick auf eine unkompliziert herstellbare elektrische Verbindung zwischen den zwei Schichtkontakten einer Datenspeicher-Einheit hat es sich als vorteilhaft erwiesen, wenn die zwei elektrisch leitenden Schichtkontakte einer Datenspeicher-Einheit in einem Abstand A im Bereich von 1 µm bis 100 µm voneinander entfernt angeordnet sind.

Es ist von Vorteil, wenn mindestens ein Schichtkontakt einer Datenspeicher-Einheit kammförmig mit mindestens zwei Kammzinken ausgebildet ist und die zwei elektrisch leitenden Schichtkontakte miteinander verzahnt angeordnet sind. Weisen beide elektrisch leitenden Schichtkontakte einer Datenspeicher-Einheit Kammstrukturen auf, so werden diese so angeordnet, dass die Kammstrukturen der beiden Schichtkontakte ineinander eingreifen, ohne sich zu berühren. Aber auch andere Formen für die Schichtkontakte sind möglich, solange Bereiche, welche die zwei elektrisch leitenden Schichtkontakte einer Datenspeicher-Einheit ausbilden, nebeneinander im Abstand A vorhanden sind. Im einfachsten Fall sind die Schichtkontakte als einfache parallele Leiterbahnen ausgebildet.

Die Schichtkontakte einer Datenspeicher-Einrichtung liegen nebeneinander bevorzugt auf einer Ebene, allerdings ist auch eine Anordnung auf unterschiedlichen Ebenen möglich, solange die Zugänglichkeit für die flüssige Substanz nicht verloren geht und der Bereich zwischen den beiden Schichtkontakten von der flüssigen Substanz benetzbar ist. Die aus der flüssigen Substanz gebildete Trockensubstanz oder erstarrte Substanz muss Schichtkontakte in unterschiedlichen Ebenen einer, insbesondere gedruckten, elektronischen Schaltung zuverlässig elektrisch leitend verbinden, wobei eine möglichst gleichmäßige Schichtdicke resultieren soll, um lokale Ohmsche Widerstände aufgrund zu geringer lokaler Leitungsquerschnitte zu vermeiden.

Sofern die flüssige Substanz auf zwei Schichtkontakte aufgetropft wird, wird ein Tropfen-Durchmesser D_{T} der flüssige Substanz vorzugsweise größer als der Abstand A gewählt. Dabei ist die Breite eines Schichtkontakts maßgebend, die direkt an den Abstand A und in Richtung des Abstands A an den Abstand A angrenzt. Je größer der Tropfen-Durchmesser im Hinblick auf den Abstand A zwischen den beiden Schichtkontakten einer Datenspeicher-Einheit gewählt wird, desto geringer sind die Anforderungen an eine exakte Plazierung des Tropfens.

Sofern die flüssige Substanz auf zwei Schichtkontakte aufgetropft wird, wobei mindestens einer kammförmig ausgebildet ist, wird ein Tropfen-Durchmesser D_{T} der flüssigen Substanz vorzugsweise mindestens so groß wie die Summe aus dem doppelten Abstand A und der dreifachen Breite einer Kammzinke gewählt. Ein gewählter Tropfen-Durchmesser muss zuverlässig eine Benetzung beider Schichtkontakte eines Datenspeicher-Elements mit der flüssigen Substanz gewährleisten, wobei die fertigungstechnisch auftretenden Lage-Toleranzen in der Positionierung der zwei Schichtkontakte berücksichtigt werden müssen. Ungenauigkeiten in der Plazierung des Tropfens dürfen auch nicht dazu führen, dass nur einer der beiden Schichtkontakte benetzt wird und somit keine elektrisch leitende Verbindung zustande kommt.

Der Tropfen-Durchmesser kann auch kleiner als der Abstand A ausgebildet werden, wenn beim Auftreffen auf die Datenspeicher-Einheit aufgrund geeigneter Oberflächenspannungen ein Verlaufen oder Auseinanderlaufen des Tropfens derart erfolgt, dass die zwei Schichtkontakte dennoch benetzt werden.

Die zwei elektrisch leitenden Schichtkontakte eines Datenspeicher-Elements weisen bevorzugt jeweils eine Dicke im Bereich von 10 nm bis 2 µm auf. Die Breite der zwei elektrisch leitenden Schichtkontakte liegt vorzugsweise jeweils im Bereich von 1 µm bis 100 µm. Dabei sind generell gleiche Breiten für die beiden Schichtkontakte einer Datenspeicher-Einheit bevorzugt.

Es hat sich bewährt, wenn die elektronische Schaltung zwei nebeneinander angeordnete Datenspeicher-Einheiten aufweist. Ein elektrisch leitender Schichtkontakt einer ersten Datenspeicher-Einheit mit mindestens einem elektrisch leitenden Schichtkontakt einer zweiten Datenspeicher-Einheit elektrisch leitend verbunden ist. Dabei ist es vorteilhaft, die nicht miteinander verbundenen Schichtkontakte der beiden Datenspeicher-Einheiten für die eine Datenspeicher-Einheit mit dem Pluspol und für die andere Datenspeicher-Einheit mit dem Minuspol einer Spannungsquelle zu verbinden. Die Programmierung der elektronischen Schaltung wird dadurch besonders fälschungssicher.

Es hat sich bewährt, sofern die mindestens eine organische elektrische Funktionsschicht der elektronischen Schaltung durch Drucken gebildet wird, dass die mindestens zwei Datenspeicher-Elemente in Druckrichtung der elektronischen Schaltung gesehen auf einer Linie hintereinander angeordnet werden. Dies erleichtert die spätere Programmierung beziehungsweise punktuelle Plazierung der flüssigen Substanz.

Bevorzugt erfolgt die Programmierung der elektronischen Schaltung in einem Rolle-zu-Rolle-Verfahren während der Herstellung der elektronischen Schaltung.

Ein elektrisch leitender Schichtkontakt einer Datenspeicher-Einheit wird gezielt an Bereiche der elektronischen Schaltung angeschlossen. Die elektronische Schaltung umfasst bevorzugt mindestens ein organisches Logikgatter, welches mit der mindestens einen Datenspeicher-Einheit elektrisch leitend verbunden ist. Die angeschlossenen Bereiche der elektronischen Schaltung befinden sich bevorzugt zwischen einem Dekoder-Bereich, in welchem die Datenspeicher-Abfragesequenz erzeugt wird, und dem organischen Logikgatter. Ein paralleles Eingangssignal wird dabei in ein sequenzielles Ausgangssignal überführt. Als organisches Logikgatter für die Realisierung der Speichereigenschaft werden üblicherweise Inverter-Bauelemente, NOR-Gatter oder NAND-Gatter eingesetzt. Das Signal des organischen Logikgatters wird je nach Beschreiben oder Nicht-Beschreiben einer Datenspeicher-Einheit unterdrückt.

Wird das Signal des Logikgatters unterdrückt, indem eine Verbindung zwischen den zwei Schichtkontakten einer Datenspeicher-Einheit ausgebildet wird oder nicht ausgebildet wird, so wird der Speicher auf den Wert "0" oder "1" gesetzt.

Das organische Inverter-Bauelement wird bevorzugt durch einen organischen Feldeffekt-Transistor (OFET) gebildet, welcher eine Drain-Elektrode und eine Source-Elektrode, eine Gate-Elektrode sowie eine halbleitende Schicht und eine elektrisch isolierende Schicht aufweist. Bevorzugt ist die mindestens eine Datenspeicher-Einheit auf der Ebene der Drain- Source- oder Gate-Elektrode angeordnet.

Es hat sich bewährt, wenn die mindestens eine Datenspeicher-Einheit in einem Versorgungs-Spannungspfad des organischen Logikgatters angeordnet ist.

Weiterhin hat es sich bewährt, die mindestens eine Datenspeicher-Einheit in einem Signal-Eingangspfad des organischen Logikgatters anzuordnen.

Weiterhin hat es sich bewährt, die mindestens eine Datenspeicher-Einheit in einem Signal-Ausgangspfad des organischen Logikgatters anzuordnen.

In dem Fall, dass zwei Datenspeicher-Einheiten vorhanden sind und diese einen gemeinsamen elektrisch leitenden Schichtkontakt aufweisen, wird vorzugsweise der gemeinsame Schichtkontakt der beiden Datenspeicher-Einheiten an das organische Logikgatter angeschlossen.

Die Verwendung einer erfindungsgemäßen elektronischen Schaltung zur Bildung kontaktlos auslesbarer Identifikations- oder Produkt-Etiketten ist ideal.

Nachfolgend soll die Erfindung nun anhand der Figuren 1 bis 5 beispielhaft erläutert werden. So zeigt
- Figur 1: zwei nebeneinander angeordnete Datenspeicher- Einheiten mit einem gemeinsamen elektrischen Schichtkontakt,
- Figur 2: eine vereinfachte Darstellung der Datenspeicher- Einheiten aus Figur 1, wobei die Datenspeicher- Einheit 2 betropft wurde.
- Figur 3: unterschiedliche Ausgangssignale bei unterschiedlicher Beschaltung eines Inverter- Bauelements im Bereich der Anschlüsse S1 und S2,
- Figur 4a: unterschiedliche Ausgangssignale bei unterschiedlicher Beschaltung eines Inverter- Bauelements im Bereich des Ausgangssignal- Kontakts Sa,
- Figur 4b: eine Detailansicht der beiden Datenspeicher- Einheiten aus Figur 4a,
- Figur 5: einen Querschnitt durch eine gedruckte elektronische Schaltung im Bereich eines OFET, welcher mit zwei Datenspeicher-Einheiten gemäß Figur 2 verbunden ist.

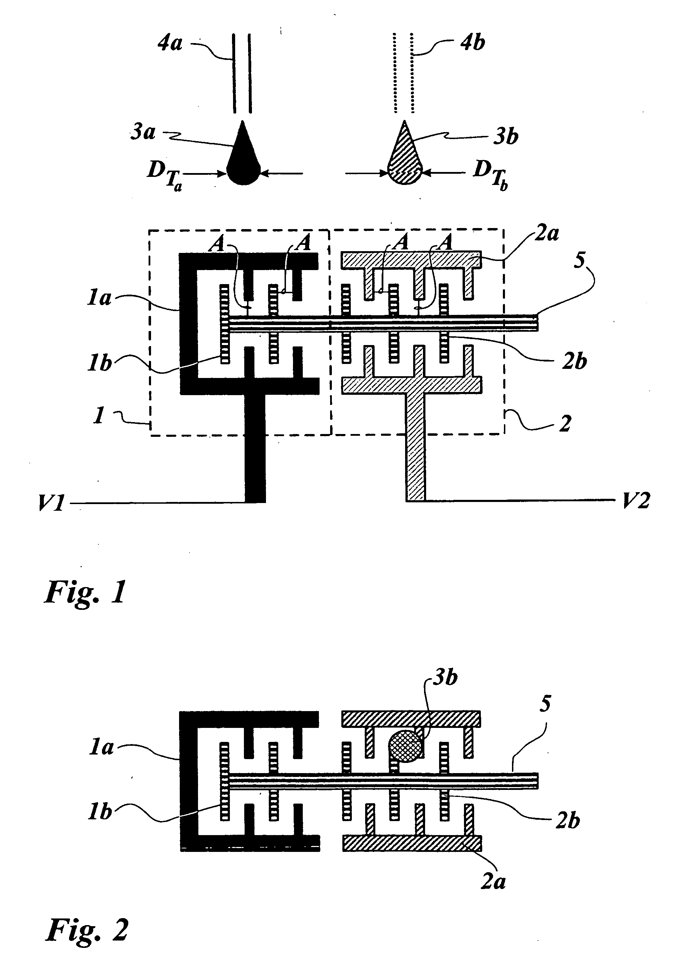

Figur 1 zeigt eine erste Datenspeicher-Einheit 1 und eine zweite Datenspeicher-Einheit 2, wie sie in der elektronischen Schaltung auftreten können, in der Draufsicht. Die erste Datenspeicher-Einheit 1 weist einen ersten elektrisch leitenden Schichtkontakt 1a und einen zweiten elektrisch leitenden Schichtkontakt 1b auf, welche voneinander in einem Abstand
A = 50 µm beabstandet in einer Ebene auf einem hier nicht dargestellten Substrat aus PET-Folie angeordnet sind. Der erste und der zweite elektrisch leitende Schichtkontakt 1a, 1b sind aus elektrisch leitendem Polypyrrol in einer Breite von 20 µm und in einer Dicke von 100 nm gebildet. Sowohl der erste als auch der zweite elektrisch leitende Schichtkontakt 1a, 1b weisen kammartige Strukturen auf, die miteinander verzahnt angeordnet sind. Am ersten Schichtkontakt 1a der ersten Datenspeicher-Einheit 1 liegt eine erste Spannung V1 an.

Die zweite Datenspeicher-Einheit 2 weist einen dritten elektrisch leitenden Schichtkontakt 2a und einen vierten elektrisch leitenden Schichtkontakt 2b auf, welche voneinander ebenfalls in einem Abstand A = 50 µm beabstandet in einer Ebene auf dem hier nicht dargestellten Substrat angeordnet sind. Der dritte und der vierte elektrisch leitende Schichtkontakt 2a, 2b sind ebenfalls aus elektrisch leitendem Polypyrrol in einer Breite von 10 µm und in einer Dicke von 100 µm gebildet. Sowohl der dritte als auch der vierte elektrisch leitende Schichtkontakt 2a, 2b weisen kammartige Strukturen auf, die miteinander verzahnt angeordnet sind. Am dritten Schichtkontakt 2a der zweiten Datenspeicher-Einheit 2 liegt eine zweite Spannung V2 an.

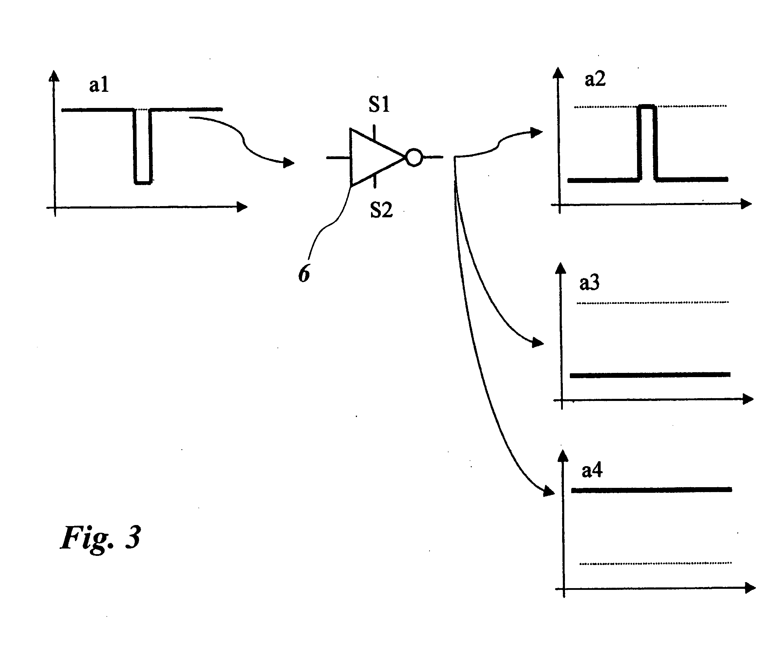

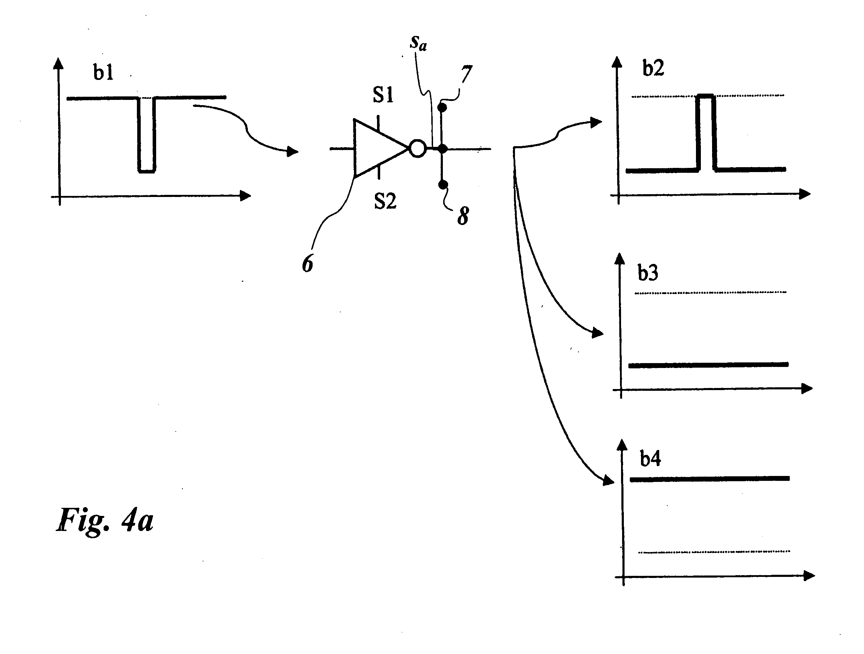

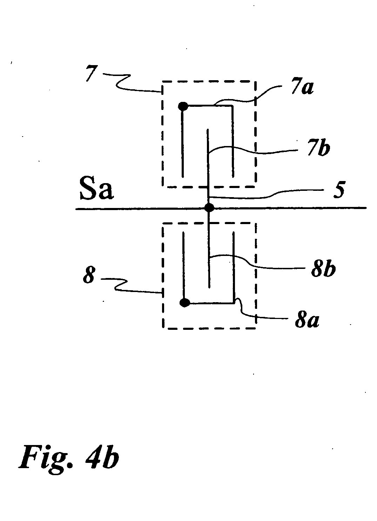

Der zweite Schichtkontakt 1b der ersten Datenspeicher-Einheit 1 ist elektrisch leitend mit dem vierten Schichtkontakt 2b der zweiten Datenspeicher-Einheit 2 verbunden. Dieser nachfolgend als gemeinsamer Schichtkontakt 1b, 2b bezeichnete Schichtkontakt ist über eine Leiterbahn 5 elektrisch leitend mit einem hier nicht gezeigten organischen Logikgatter, hier einem organischen Inverter-Bauelement 6 (siehe Figuren 3 und 4) der elektronischen Schaltung verbunden.

Oberhalb der ersten Datenspeicher-Einheit 1 ist ein erster Tropfen 3a einer flüssigen Substanz dargestellt, welcher mittels einer Kapillare 4a auf die erste Datenspeicher-Einheit 1 getropft werden kann. Oberhalb der zweiten Datenspeicher-Einheit 2 ist ein zweiter Tropfen 3b einer flüssigen Substanz dargestellt, welcher mittels einer Kapillare 4b auf die zweite Datenspeicher-Einheit 2 getropft werden kann. Dabei kann wahlweise der erste Tropfen 3a und/oder der zweite Tropfen 3b oder aber keiner von beiden aufgetropft werden. Ein auf die erste Datenspeicher-Einheit 1 aufgetropfter erster Tropfen 3a soll den ersten Schichtkontakt 1a sowie den zweiten Schichtkontakt 1b benetzen. Ein Tropfen-Durchmesser D_{Ta} des ersten Tropfens 3a ist in Abstimmung zum Abstand A entsprechend zu wählen. Nach dem Trocknen oder Erstarren des ersten Tropfens 3a liegt eine elektrisch leitende Verbindung zwischen dem ersten Schichtkontakt 1a und dem zweiten Schichtkontakt 1b vor, so dass die erste Spannung V1 über die Leiterbahn 5 am nicht dargestellten Inverter-Bauelement anliegt. ,

Ein auf die zweite Datenspeicher-Einheit 2 aufgetropfter zweiter Tropfen 3b soll den dritten Schichtkontakt 2a sowie den vierten Schichtkontakt 2b benetzen. Ein Tropfen-Durchmesser D_{Tb} des zweiten Tropfens 3b ist in Abstimmung zum Abstand A entsprechend zu wählen. Nach dem Trocknen oder Erstarren des zweiten Tropfens 3b liegt eine elektrisch leitende Verbindung zwischen dem dritten Schichtkontakt 2a und dem vierten Schichtkontakt 2b vor, so dass die zweite Spannung V2 über die Leiterbahn 5 am nicht dargestellten Inverter-Bauelement anliegt.

Werden sowohl der erste Tropfen 3a als auch der zweite Tropfen 3b aufgetropft, werden V1 und V2 verbunden. Liegt beispielsweise am ersten Schichtkontakt 1a eine positive Spannung an und liegt der dritte Schichtkontakt 2a auf Erde, so wird ein Kurzschluss erzeugt. Mit der in Figur 1 dargestellten Datenspeicher-Anordnungen ist ein Inverter-Bauelement einer elektronischen Schaltung somit in einfacher Weise mit unterschiedlichen Signalen beschaltbar.

Als flüssige Substanz wird eine Lösung enthaltend Polypyrrol als elektrisch leitenden Stoff eingesetzt.

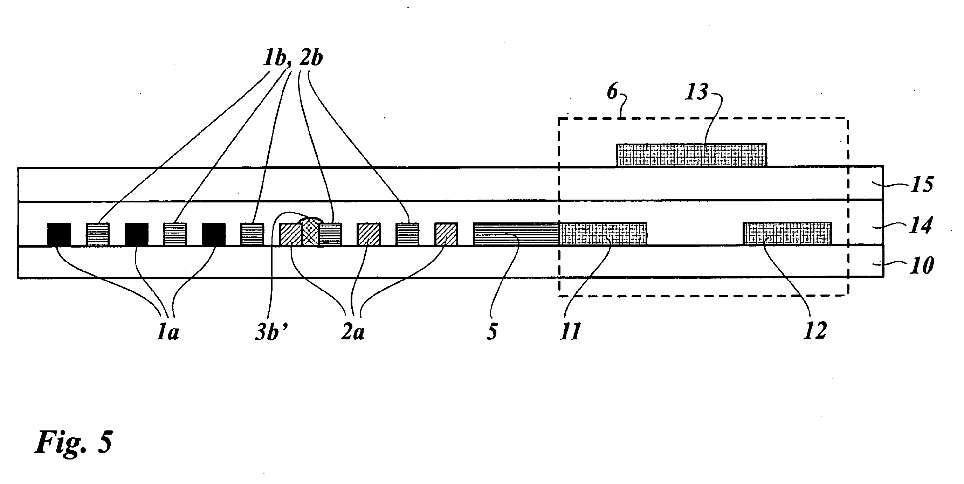

Figur 2 zeigt eine vereinfachte Darstellung der ersten und der zweiten Datenspeicher-Einheiten 1, 2. Auf die zweite Datenspeicher-Einheit 2 (siehe Figur 1) wurde der zweite Tropfen 3b aufgetropft, während die erste Datenspeicher-Einheit 1 nicht betropft wurde. Der zweite Tropfen 3b benetzt sowohl Bereiche des dritten Schichtkontakts 2a als auch des vierten Schichtkontakts 2b und wird getrocknet. Nach der Trocknung verbleibt eine elektrisch leitende Verbindung in Form einer Trockensubstanz (Siehe Figur 5, Ziffer 3b'), hier in Form von elektrisch leitendem Polypyrrol.

Figur 3 zeigt nun unterschiedliche Beispiele, wie ein Inverter-Bauelement 6 mittels der ersten und der zweiten Datenspeicher-Einheit 1, 2 gemäß Figur 1 programmiert werden kann. Ein Eingangssignal a1 in das Inverter-Bauteil 6 wird je nach Programmierung der beiden Datenspeicher-Einheiten 1, 2 zu einem Ausgangssignal a2, a3 oder a4 verändert.

### Fall 1: Eingangssignal a1 wird in das Ausgangssignal a2 umgewandelt

Um dies zu realisieren, wird die Datenspeicher-Einheit 1 gemäß Figur 1 mit dem ersten Tropfen 3a betropft und eine elektrisch leitende Verbindung zwischen dem ersten Schichtkontakt 1a und dem zweiten Schichtkontakt 1b ausgebildet. Die zweite Datenspeicher-Einheit 2 wird nicht betropft. Die Leiterbahn 5 ist an den Kontakt S1 des Inverter-Bauelements 6 angeschlossen. Die beiden Anschlüsse S1 und S2 des Inverter-Bauelements 6 ermöglichen den Anschluss des Inverter-Bauelements 6 an eine Versorgungs-Spannung. In diesem Fall liegt an dem zweiten Schichtkontakt 1b der ersten Datenspeicher-Einheit 1 und somit auch an Anschluss S1 die Spannung V1 an, welche die Versorgungs-Spannung für das Inverter-Bauelement 6 bereitstellt. Der Anschluss S2 des Inverter-Bauelements 6 wird auf Erde gelegt.

### Fall 2: Eingangssignal a1 wird in das Ausgangssignal a3 umgewandelt

Um dies zu realisieren, wird die Datenspeicher-Einheit 2 gemäß Figur 1 mit dem zweiten Tropfen 3b betropft und eine elektrisch leitende Verbindung zwischen dem dritten Schichtkontakt 2a und dem vierten Schichtkontakt 2b ausgebildet. Die erste Datenspeicher-Einheit 1 wird nicht betropft. Die Leiterbahn 5 ist an den Kontakt S1 des Inverter-Bauelements 6 angeschlossen. In diesem Fall ist der vierte Schichtkontakt 2b der zweiten Datenspeicher-Einheit 2 und somit auch der Anschluss S1 mit Erde verbunden. Der Anschluss S2 des Inverter-Bauelements 6 wird ebenfalls auf Erde gelegt.

### Fall 3: Eingangssignal a1 wird in das Ausgangssignal a4 umgewandelt

Um dies zu realisieren, wird die Datenspeicher-Einheit 1 gemäß Figur 1 mit dem ersten Tropfen 3a betropft und eine elektrisch leitende Verbindung zwischen dem ersten Schichtkontakt 1a und dem zweiten Schichtkontakt 1b ausgebildet. Die zweite Datenspeicher-Einheit 2 wird nicht betropft. Die Leiterbahn 5 ist an den Anschluß S2 des Inverter-Bauelements 6 angeschlossen. Der Anschluß S1 ist mit der Spannung V1 verbunden. In diesem Fall liegt an dem zweiten Schichtkontakt 1b der ersten Datenspeicher-Einheit 1 und somit auch an dem Anschluß S2 die Spannung V1 an, welche die Versorgungs-Spannung für das Inverter-Bauelement 6 bereitstellt.

Bei den Varianten nach den oben beschriebenen Fällen 1 und 2 sind somit die Datenspeicher-Einheiten 1 und 2 nach Fig. 1 mit ihrer Leiterbahn 5 mit dem Anschluß S1 des Inverter-Bauelements 6 verbunden, wobei der Anschluß S2 des Inverter-Bauelements mit Erde verbunden ist. Bei der Variante nach Fall 3 sind die Datenspeicher-Einheiten 1 und 2 mit ihrer Leiterbahn 5 mit dem Anschluß S2 des Inverter-Bauelements 6 verbunden, wobei der Anschluß S1 mit der Versorgungs-Spannung verbunden ist. Weiter ist es auch möglich, daß die in Fig. 1 gezeigten Datenspeicher-Einheiten 1 und 2 nicht nur mit einem Anschluß des Inverter-Bauelements 6 verbunden sind, sondern daß jeweils zwei nach Fig. 1 verschaltete Datenspeicher-Einheiten mit ihrer Leiterbahn 5 mit dem Anschluß S1 und zwei weitere nach Fig. 1 verschaltete Datenspeicher-Einheiten mit dem Anschluß S2 verbunden sind. Hierdurch ist es möglich, durch entsprechendes Betropfen der einzelnen Datenspeicher-Einheiten auf das Eingangssignal a1 sämtliche der vorgehend beschriebenen Ausgangssignale a2, a3 oder a4 zu generieren.

Gemäß eines weiteren Ausführungsbeispiels der Erfindung ist lediglich eine Datenspeicher-Einheit, die beispielsweise wie die Datenspeicher-Einheit 1 nach Fig. 1 aufgebaut ist, mit dem Anschluß S1 oder dem Anschluß S2 des Inverter-Bauelements 6 verbunden. Eine der elektrisch leitenden Schichtkontakte der Datenspeicher-Einheiten ist somit mit dem Anschluß S1 oder S2 verbunden und der andere elektrisch leitende Schichtkontakt der Datenspeicher-Einheit ist mit der Versorgungs-Spannung bzw. der Erde verbunden. Hierbei ist weiter vorgesehen, daß der Anschluß des Inverter-Bauelements 6, der mit der Datenspeicher-Einheit verbunden ist, weiter über einen hochohmigen Widerstand mit Erde bzw. mit der Versorgungs-Spannung V1 verbunden ist. Wird die Datenspeicher-Einheit nicht betropft, so sind in der ersten Ausführungsvariante sowohl der Anschluß S1 (über den hochohmigen Widerstand) als auch der Anschluß S2 mit Masse verbunden und in der anderen Ausführungsvariante sowohl der Anschluß S1 als auch der Anschluß S2 (über den hochohmigen Widerstand) mit der Versorgungs-Spannung V1 verbunden. Ist die Datenspeicher-Einheit betropft, so ist in beiden Ausführungsvarianten der Anschluß S1 mit der Versorgungs-Spannung V1 und der Anschluß S2 mit Masse verbunden, so daß auf das Eingangssignal a1 das Ausgangssignal a2 nach Fig. 3 generiert wird. Durch diese Verschaltung wird sichergestellt, daß auch bei Einsatz einer einzelnen Datenspeicher-Einheit sich das Inverter-Bauelement 6 immer in einem definierten Zustand befindet und eine Signalverzerrung durch ein "Mitschwingen" eines potentialfreien Anschlusses der Datenspeicher-Einheit 1 vermieden wird.

Es ist weiter auch möglich, eine Datenspeicher-Einheit wie oben beschrieben mit dem Anschluß S1 und eine weitere Datenspeicher-Einheit mit dem Anschluß S2 des Inverter-Bauelements zu verbinden. Hierdurch wird der Vorteil erzielt, daß mit nur zwei Datenspeicher-Einheiten auf das Eingangssignal a1 sämtliche Ausgangssignale a2 bis a4 generiert werden können.

Figur 4a zeigt nun unterschiedliche Beispiele, wie ein Inverter-Bauelement 6 mittels zwei Datenspeicher-Einheiten 7, 8 programmiert werden kann, welche am Signalausgang Sa des Inverter-Bauelements 6 angeschlossen sind. Ein Eingangssignal b1 in das Inverter-Bauelement 6 wird je nach Programmierung der beiden Datenspeicher-Einheiten 7, 8 zu einem Ausgangssignal b2, b3 oder b4 verändert. Die beiden Anschlüsse S1 und S2 des Inverter-Bauelements 6 ermöglichen den Anschluss des Inverter-Bauelements 6 an eine Versorgungs-Spannung, wobei an S1 die Versorgungs-Spannung anliegt und S2 mit Erde verbunden ist. Aus Figur 4b wird ersichtlich, dass die erste Datenspeicher-Einheit 7 einen ersten Schichtkontakt 7a und einen zweiten Schichtkontakt 7b aufweist. Der erste Schichtkontakt 7a ist - hier nicht dargestellt - mit dem Anschluss S1 verbunden. Die zweite Datenspeicher-Einheit 8 weist einen dritten Schichtkontakt 8a und einen vierten Schichtkontakt 8b auf. Der dritte Schichtkontakt 8a ist - hier nicht dargestellt - mit dem Anschluss S2 (Erde) verbunden. Die Leiterbahn 5 ist an den Ausgangssignal - Kontakt Sa des Inverter-Bauelements 6 angeschlossen und verbindet den zweiten Schichtkontakt 7b, den vierten Schichtkontakt 8b und den Ausgangssignal - Kontakt Sa des Inverter-Bauelements 6.

### Fall 4: Eingangssignal b1 wird in das Ausgangssignal b2 umgewandelt

Um dies zu realisieren, wird weder die erste Datenspeicher-Einheit 7 noch die zweite Datenspeicher-Einheit 8, deren Aufbau aus Figur 4b deutlich ersichtlich wird, betropft. Der erste und der zweite Schichtkontakt 7a, 7b sowie der dritte und der vierte Schichtkontakt 8a, 8b bleiben voneinander elektrisch isoliert.

### Fall 5: Eingangssignal b1 wird in das Ausgangssignal b3 umgewandelt

Um dies zu realisieren, wird die zweite Datenspeicher-Einheit 8, deren Aufbau aus Figur 4b deutlich ersichtlich wird, betropft und eine elektrisch leitende Verbindung zwischen dem dritten Schichtkontakt 8a und dem vierten Schichtkontakt 8b ausgebildet. Die erste Dätenspeicher-Einheit 7 wird nicht betropft. In diesem Fall liegt der vierte Schichtkontakt 8b der zweiten Datenspeicher-Einheit 8 und somit der Anschluss Sa auf Erde.

### Fall 6: Eingangssignal b1 wird in das Ausgangssignal b4 umgewandelt

Um dies zu realisieren, wird die erste Datenspeicher-Einheit 7, deren Aufbau aus Figur 4b deutlich ersichtlich wird, betropft und eine elektrisch leitende Verbindung zwischen dem ersten Schichtkontakt 7a und dem zweiten Schichtkontakt 7b ausgebildet. Die zweite Datenspeicher-Einheit 8 wird nicht betropft. In diesem Fall liegt an dem zweiten Schichtkontakt 7b der ersten Datenspeicher-Einheit 7 und somit auch an Anschluss Sa die Spannung V1 an.

Figur 5 zeigt einen Querschnitt durch einen Bereich einer gedruckten elektronischen Schaltung im Bereich eines als OFET ausgebildeten organischen Inverter-Bauelements 6, welches mit den Datenspeicher-Einheiten 1, 2 gemäß Figur 2 verbunden ist. Auf einem flexiblen Substrat 10 aus PET-Folie sind der elektrisch leitende erste und dritte Schichtkontakt 1a, 2a sowie der gemeinsame Schichtkontakt 1b, 2b zu erkennen. Der Schnitt durch die Datenspeicher-Einheiten 1, 2 gemäß Figur 2 ist in Höhe der elektrisch leitenden Trockensubstanz aus Polypyrrol geführt und schließlich in Höhe der Leiterbahn 5 bis zu einem in Figur 2 nicht dargestellten Inverter-Bauelement 6 geführt. Die aus dem Tropfen 3b gemäß Figur 2 verbliebene Trockensubstanz ist mit der Bezugsziffer 3b' gekennzeichnet.Das Inverter-Bauelement 6, welches durch einen OFET repräsentiert wird, weist in der Ebene der Datenspeicher-Einheiten 1, 2 eine Source-Elektrode 11 und eine Drain-Elektrode 12 auf, wobei die elektrisch leitenden Schichtkontakte 1a, 1b, 2a, 2b, die Source-Elektrode 11 sowie die Drain-Elektrode 12 aus dem gleichen Material und in einem Arbeitsgang gedruckt wurden. Eine vollflächige halbleitende organische Schicht 14 aus P3AT bedeckt die Datenspeicher-Einheiten 1, 2 sowie die Source- und Drain-Elektroden 11, 12. Auf der halbleitenden Schicht 14 befindet sich eine vollflächige elektrisch isolierende Schicht 15 aus PHS, PMMA sowie eine Gate-Elektrode 13. Die gemeinsame Schichtelektrode 1b, 2b der Datenspeicher-Einheiten 1, 2 ist elektrisch leitend mit der Source-Elektrode 11 verbunden, so dass an der Source-Elektrode 11 die Spannung V2 (siehe Figur 1) anliegt. Eine nachträgliche Umprogrammierung der elektronischen Schaltung wird durch die Integration der elektrisch leitenden Trockensubstanz 3b' in den Schichtaufbau der Schaltung unmöglich gemacht.

In Kenntnis der Erfindung werden dem Fachmann eine Vielzahl weiterer Möglichkeiten eröffnet, das erfindungsgemäße Verfahren zur Programmierung elektronischer Schaltungen einzusetzen, ohne dabei erfinderisch tätig werden zu müssen. So können unterschiedlichste Logikgatter in Kombination mit einer oder mehreren Datenspeicher-Einheiten, welche eine Programmierung durch Auftragen einer flüssigen Substanz ermöglichen, für die erfindungsgemäße elektronische Schaltung eingesetzt werden.

## Patentansprüche

1. Verfahren zum Programmieren einer elektronischen Schaltung, welche mindestens eine organische elektrische Funktionsschicht und zwei Datenspeicher-Einheiten (1, 2; 7, 8) aufweist, wobei jede der zwei Datenspeicher-Einheiten (1, 2; 7, 8) mit einem ersten elektrisch leitenden Schichtkontakt (1a; 2a; 7a; 8a) und einem zweiten elektrisch leitenden Schichtkontakt (1b; 2b; 7b; 8b)ausgebildet wird, wobei der erste und der zweite elektrisch leitende Schichtkontakt (1a, 1b; 2a, 2b; 7a, 7b; 8a, 8b) benachbart voneinander gebildet werden, wobei die zweiten Schichtkontakte (1b, 2b; 7b, 8b) der zwei Datenspeicher-Einheiten (1, 2; 7, 8) elektrisch leitend verbunden werden, und wobei eine flüssige Substanz enthaltend einen elektrisch leitenden Stoff derart auf eine der zwei Datenspeicher-Einheiten (1, 2; 7, 8) aufgebracht wird, dass die flüssige Substanz den ersten und den zweiten elektrisch leitenden Schichtkontakt (1a, 1b; 2a, 2b; 7a, 7b; 8a, 8b) zumindest teilweise benetzt,
**dadurch gekennzeichnet, dass** an die ersten Schichtkontakte (1a, 2a; 7a, 8a) der zwei Datenspeicher-Einheiten (1, 2; 7, 8) unterschiedliche Spannungen (V1, V2) angelegt werden.

2. Verfahren nach Anspruch 1,
**dadurch gekennzeichnet,**
**dass** die flüssige Substanz aufgetropft oder aufgetupft

3. Verfahren nach einem der Ansprüche 1 bis 2,
**dadurch gekennzeichnet,**
**dass** die flüssige Substanz in Form einer Lösung, einer Suspension, einer Tinte oder einer Paste aufgebracht wird.

4. Verfahren nach Anspruch 1,
**dadurch gekennzeichnet,**
**dass** die flüssige Substanz in Form einer Schmelze aufgebracht wird, dass eine Abkühlung der flüssigen Substanz erfolgt und dass eine elektrisch leitende erstarrte Substanz umfassend den elektrisch leitenden Stoff gebildet wird, welche den ersten und den zweiten elektrisch leitenden Schichtkontakt (1a, 1b; 2a, 2b; 7a, 7b; 8a, 8b) elektrisch leitend miteinander verbindet.

5. Elektronische Schaltung, insbesondere her stellbar nach einem der Ansprüche 1 bis 4, welche mindestens eine organische elektrische Funktionsschicht und zwei Datenspeicher-Einheiten (1, 2; 7, 8) aufweist, wobei jede Datenspeicher-Einheit (1, 2, 7, 8) einen ersten und einen zweiten elektrisch leitenden Schichtkontakt (1a, 1b; 2a, 2b; 7a, 7b; 8a, 8b) aufweist, , wobei
der erste und der zweite elektrisch leitende Schichtkontakt (1a, 1b; 2a, 2b; 7a, 7b; 8a, 8b) benachbart voneinander angeordnet sind, wobei
die zweiten Schichtkontakte (1b, 2b; 7b, 8b) der zwei Datenspeicher-Einheiten (1, 2; 7, 8) elektrisch leitend miteinander verbunden sind, und wobei
a) eine elektrisch leitende Trockensubstanz oder
b) eine elektrisch leitende erstarrte Substanz den ersten und den zweiten elektrisch leitenden Schichtkontakt (1a, 1b; 2a, 2b; 7a, 7b; 8a, 8b) einer der zwei Datenspeicher-Einheiten (1, 2; 7, 8) elektrisch leitend miteinander verbindet,
**dadurch gekennzeichnet, dass** an die ersten Schichtkontakte (1a, 2a; 7a, 8a) der zwei Datenspeicher-Einheiten (1, 2; 7, 8) unterschiedliche Spannungen (V1, V2) angelegt sind.

6. Elektronische Schaltung nach Anspruch 5,
**dadurch gekennzeichnet,**
**dass** die elektronische Schaltung mindestens ein organisches Logikgatter umfasst, welches mit den zwei Datenspeicher-Einheiten (1, 2; 7, 8) elektrisch leitend verbunden ist.

7. Elektronische Schaltung nach Anspruch 6,
**dadurch gekennzeichnet,**
**dass** das organische Logikgatter durch ein organisches Inverter-Bauelement (6), ein organisches NAND-Gatter oder ein organisches NOR-Gatter gebildet ist.

8. Elektronische Schaltung nach Anspruch 6,
**dadurch gekennzeichnet,**
**dass** das organische Inverter-Bauelement durch einen organischen Feldeffekt-Transistor (OFET) gebildet ist, welcher eine Drain-Elektrode (12) und eine Source-Elektrode (11), eine Gate-Elektrode (13) sowie eine halbleitende Schicht (14) und eine elektrisch isolierende Schicht (15) aufweist.

9. Elektronische Schaltung nach Anspruch 8,
**dadurch gekennzeichnet,**
**dass** die zwei Datenspeicher-Einheiten (1, 2) auf Ebene der Drain-Elektrode, der Source-Elektrode oder der Gate-Elektrode angeordnet sind.

10. Elektronische Schaltung nach einem der Ansprüche 6 bis 9, **dadurch gekennzeichnet,**
**dass** die zwei Datenspeicher-Einheiten (1, 2, 7, 8) in einem Versorgungs-Spannungspfad des organischen Logikgatters angeordnet sind.

11. Elektronische Schaltung nach einem der Ansprüche 6 bis 9,
**dadurch gekennzeichnet,**
**dass** die zwei Datenspeicher-Einheiten (1, 2, 7, 8) in einem Signaleingangspfad des organischen Logikgatters angeordnet ist.

12. Elektronische Schaltung nach einem der Ansprüche 6 bis 9,
**dadurch gekennzeichnet,**
**dass** die zwei Datenspeicher-Einheiten (1, 2, 7, 8) in einem Signalausgangspfad des organischen Logikgatters angeordnet sind.

13. Elektronische Schaltung nach einem der Ansprüche 5 bis 12,
**dadurch gekennzeichnet,**
**dass** der erste und/oder der zweite elektrisch leitende Schichtkontakt (1a, 1b; 2a, 2b) einer Datenspeicher-Einheit (1, 2, 7, 8) kammförmig mit mindestens zwei Kammzinken ausgebildet ist und der erste und der zweite elektrisch leitende Schichtkontakt (1a, 1b; 2a, 2b;7a, 7b; 8a, 8b) miteinander verzahnt angeordnet sind.

14. Elektronische Schaltung nach einem der Ansprüche 5 bis 13,
**dadurch gekennzeichnet,**
**dass** die ersten und zweiten elektrisch leitenden Schichtkontakte (1a, 1b; 2a, 2b; 7a, 7b; 8a, 8b) aus einem metallischen oder organischen elektrisch leitenden Material gebildet sind.

15. Elektronische Schaltung nach einem der Ansprüche 5 bis 14,
**dadurch gekennzeichnet,**
**dass** in Fall a) die elektrisch leitende Trockensubstanz oder in Fall b) die elektrisch leitende erstarrte Substanz einen elektrisch leitenden Stoff aus der Gruppe der metallischen und/oder organischen leitenden Materialien aufweist.

## Claims

1. Method for programming an electronic circuit having at least one organic electrical functional layer and two data storage units (1, 2; 7, 8), each of the two data storage units (1, 2; 7, 8) being configured with a first electrically conductive layer contact (1a; 2a; 7a; 8a) and a second electrically conductive layer contact (1b; 2b; 7b; 8b), the first and the second electrically conductive layer contact (1a, 1b; 2a, 2b; 7a, 7b; 8a, 8b) being formed adjacent from one another, the second layer contacts (1b, 2b; 7b, 8b) of the two data storage units (1, 2; 7, 8) being electrically conductively connected, and a liquid substance containing an electrically conductive material being applied to one of the two data storage units (1, 2; 7, 8) in such a way that the liquid substance at least partly wets the first and the second electrically conductive layer contact (1a, 1b; 2a, 2b; 7a, 7b; 8a, 8b), **characterized in that** different voltages (V1, V2) are applied to the first layer contacts (1a, 2a; 7a, 8a) of the two data storage units (1, 2; 7, 8).

2. Method according to Claim 1,
**characterized**
**in that** the liquid substance is applied dropwise or dabbed on.

3. Method according to either of Claims 1 and 2,
**characterized**
**in that** the liquid substance is applied in the form of a solution, a suspension, an ink or a paste.

4. Method according to Claim 1,
**characterized**
**in that** the liquid substance is applied in the form of a melt, in that the liquid substance is cooled, and in that an electrically conductive solidified substance comprising the electrically conductive material is formed, which electrically conductively connects the first and the second electrically conductive layer contact (1a, 1b; 2a, 2b; 7a, 7b; 8a, 8b) to one another.

5. Electronic circuit, in particular which can be produced according to any of Claims 1 to 4, having at least one organic electrical functional layer and two data storage units (1, 2; 7, 8), each data storage unit (1, 2, 7, 8) having a first and a second electrically conductive layer contact (1a, 1b; 2a, 2b; 7a, 7b; 8a, 8b), the first and the second electrically conductive layer contact (1a, 1b; 2a, 2b; 7a, 7b; 8a, 8b) being arranged adjacent from one another, the second layer contacts (1b, 2b; 7b, 8b) of the two data storage units (1, 2; 7, 8) being electrically conductively connected to one another, and
a) an electrically conductive dry substance or
b) an electrically conductive solidified substance electrically conductively connecting the first and the second electrically conductive layer contact (1a, 1b; 2a, 2b; 7a, 7b; 8a, 8b) of one of the two data storage units (1, 2; 7, 8) to one another, **characterized in that** different voltages (V1, V2) are applied to the first layer contacts (1a, 2a; 7a, 8a) of the two data storage units (1, 2; 7, 8).

6. Electronic circuit according to Claim 5,
**characterized**
**in that** the electronic circuit comprises at least one organic logic gate which is electrically conductively connected to the two data storage units (1, 2; 7, 8).

7. Electronic circuit according to Claim 6,
**characterized**
**in that** the organic logic gate is formed by an organic inverter component (6), an organic NAND gate or an organic NOR gate.

8. Electronic circuit according to Claim 6,
**characterized**
**in that** the organic inverter component is formed by an organic field effect transistor (OFET) having a drain electrode (12) and a source electrode (11), a gate electrode (13) and also a semiconducting layer (14) and an electrically insulating layer (15).

9. Electronic circuit according to Claim 8,
**characterized**
**in that** the two data storage units (1, 2) are arranged at the level of the drain electrode, source electrode or the gate electrode.

10. Electronic circuit according to any of Claims 6 to 9,
**characterized**
**in that** the two data storage units (1, 2, 7, 8) are arranged in a supply voltage path of the organic logic gate.

11. Electronic circuit according to any of Claims 6 to 9,
**characterized**
**in that** the two data storage units (1, 2, 7, 8) are arranged in a signal input path of the organic logic gate.

12. Electronic circuit according to any of Claims 6 to 9,
**characterized**
**in that** the two data storage units (1, 2, 7, 8) are arranged in a signal output path of the organic logic gate.

13. Electronic circuit according to any of Claims 5 to 12,
**characterized**
**in that** the first and/or the second electrically conductive layer contact (1a, 1b; 2a, 2b) of a data storage unit (1, 2, 7, 8) is configured in comb-shaped fashion with at least two comb tines and the first and the second electrically conductive layer contact (1a, 1b; 2a, 2b; 7a, 7b; 8a, 8b) are arranged in a manner intermeshed with one another.

14. Electronic circuit according to any of Claims 5 to 13,
**characterized**
**in that** the first and second electrically conductive layer contacts (1a, 1b; 2a, 2b; 7a, 7b; 8a, 8b) are formed from a metallic or organic electrically conductive material.

15. Electronic circuit according to any of Claims 5 to 14,
**characterized**
**in that** in case a) the electrically conductive dry substance or in case b) the electrically conductive solidified substance has an electrically conductive material from the group of the metallic and/or organic conductive materials.

## Revendications

1. Procédé de programmation d'un circuit électronique qui comporte au moins une couche fonctionnelle électrique organique et deux unités de mémoire de données (1, 2 ; 7, 8), chacune des deux unités de mémoire de données (1, 2 ; 7, 8) étant formée d'un premier contact de couche électro-conducteur (1a ; 2a ; 7a ; 8a) et d'un deuxième contact de couche électro-conducteur (1b ; 2b ; 7b ; 8b), les premier et deuxième contacts de couche électro-conducteurs (1a, 1b ; 2a, 2b ; 7a, 7b ; 8a, 8b) étant formés à proximité l'un de l'autre, les deuxièmes contacts de couche (1b, 2b ; 7b, 8b) des deux unités de mémoire de données (1, 2 ; 7, 8) étant reliés d'une manière électro-conductrice et une substance liquide contenant une matière électro-conductrice est appliquée sur une des deux unités de mémoire de données (1, 2 ; 7, 8) de manière telle que la substance liquide mouille au moins partiellement les premier et deuxième contacts de couche électro-conducteurs (1a, 1b ; 2a, 2b ; 7a, 7b ; 8a, 8b),
**caractérisé en ce que** différentes tensions (V1, V2) sont appliquées sur les premier et deuxième contacts de couche (1a, 2a ; 7a, 8a) des deux unités de mémoire de données (1, 2 ; 7, 8).

2. Procédé selon la revendication 1,
**caractérisé en ce**
**que** la substance liquide est versée ou tamponnée goutte à goutte.

3. Procédé selon l'une quelconque des revendications 1 à 2,
**caractérisé en ce**
**que** la substance liquide est appliquée sous forme d'une solution, d'une suspension, d'une encre ou d'une pâte.

4. Procédé selon la revendication 1,
**caractérisé en ce**
**que** la substance liquide est appliquée sous forme d'une matière fondue, en ce qu'un refroidissement de la substance liquide a lieu et en ce qu'il se forme une substance solidifiée électro-conductrice comportant la matière électro-conductrice qui relie d'une manière électro-conductrice les premier et deuxième contacts de couche (1a, 1b ; 2a, 2b ; 7a, 7b ; 8e, 8b) électro-conducteurs.

5. Circuit électronique, pouvant être fabriqué en particulier selon l'une quelconque des revendications 1 à 4, lequel comporte au moins une couche fonctionnelle électrique organique et deux unités de mémoire de données (1, 2 ; 7, 8), chaque unité de mémoire de données (1, 2, 7, 8) comportant un premier et un deuxième contacts de couche (1a, 1b ; 2a, 2b ; 7a, 7b ; 8a, 8b) électro-conducteurs, les premier et deuxième contacts de couche (1a, 1b ; 2a, 2b ; 7a, 7b ; 8a, 8b) électro-conducteurs étant disposés à proximité l'un de l'autre, les deuxièmes contacts de couche (1b, 2b ; 7b, 8b) des deux unités de mémoire de données (1, 2 ; 7, 8) étant reliés entre eux d'une manière électro-conductrice, et
a) une substance sèche électro-conductrice ou
b) une substance solidifiée électro-conductrice reliant entre eux d'une manière électro-conductrice les premier et deuxième contacts de couche électro-conducteurs (1a, 1b ; 2a, 2b ; 7a, 7b ; 8a, 8b) des deux unités de mémoire de données (1, 2 ; 7, 8), **caractérisé en ce que** différentes tensions (V1, V2) sont appliquées sur les premiers contacts de couche (1a, 2a ; 7a, 8a) des deux unités de mémoire de données (1, 2 ; 7, 8).

6. Circuit électronique selon la revendication 5,
**caractérisé en ce**
**que** le circuit électronique comprend au moins une porte logique organique qui est reliée d'une manière électro-conductrice aux deux unités de mémoire de données (1, 2 ; 7, 8).

7. Circuit électronique selon la revendication 6,
**caractérisé en ce**
**que** la porte logique organique est formée par un composant inverseur organique (6), une porte NON-ET organique ou une porte NON-OU organique.

8. Circuit électronique selon la revendication 6,
**caractérisé en ce**
**que** le composant inverseur organique est formé par un transistor à effet de champ organique (OFET) qui comporte une électrode de drain (12) et une électrode de source (11), une électrode de grille (13) ainsi qu'une couche semi-conductrice (14) et une couche électriquement isolante (15).

9. Circuit électronique selon la revendication 8,
**caractérisé en ce**
**que** les deux unités de mémoire de données (1, 2) sont disposées sur un plan de l'électrode de drain, de l'électrode de source ou de l'électrode de grille.

10. Circuit électronique selon l'une quelconque des revendications 6 à 9,
**caractérisé en ce**
**que** les deux unités de mémoire de données (1, 2, 7, 8) sont disposées dans un chemin de tension d'alimentation de la porte logique organique.

11. Circuit électronique selon l'une quelconque des revendications 6 à 9,
**caractérisé en ce**
**que** les deux unités de mémoire de données (1, 2, 7, 8) sont disposées dans un chemin d'entrée de signal de la porte logique organique.

12. Circuit électronique selon l'une quelconque des revendications 6 à 9,
**caractérisé en ce**
**que** les deux unités de mémoire de données (1, 2, 7, 8) sont disposées dans un chemin de sortie de signal de la porte logique organique.

13. Circuit électronique selon l'une quelconque des revendications 5 à 12,
**caractérisé en ce**
**que** le premier et/ou le deuxième contact de couche électro-conducteur (1a, 1b ; 2a, 2b) d'une unité de mémoire de données (1, 2, 7, 8) a une forme de peigne avec au moins deux dents de peigne et en ce que les premier et deuxième contacts de couche électro-conducteurs (1a, 1b ; 2a, 2b ;7a, 7b ; 8a, 8b) sont disposés d'une manière imbriquée l'un dans l'autre.

14. Circuit électronique selon l'une quelconque des revendications 5 à 13,
**caractérisé en ce**
**que** les premier et deuxième contacts de couche électro-conducteurs (1a, 1b ; 2a, 2b ; 7a, 7b ; 8a, 8b) sont composé d'un matériau métallique ou organique électro-conducteur.

15. Circuit électronique selon l'une quelconque des revendications 5 à 14,
**caractérisé en ce**
**que** la substance sèche électro-conductrice dans le cas a) ou la substance solidifiée électro-conductrice dans le cas b) comporte une matière électro-conductrice du groupe des matériaux conducteurs métalliques et/ou organiques.
